# EUROPEAN PATENT SPECIFICATION

(11) **EP 2 166 567 B1**
(45) Date of publication and mention of the grant of the patent: **09.04.2014**
(21) Application number: 08790736.6
(22) Date of filing: 30.06.2008
(51) Int. Cl.: H01L 21/687, H01L 21/677

(54) **SUBSTRATE TRANSFER ROBOT**
SUBSTRATÜBERTRAGUNGSROBOTER
ROBOT DE TRANSFERT DE SUBSTRAT

(30) Priority: 29.06.2007 JP 2007172871
(43) Date of publication of application: 24.03.2010
(73) Proprietor: Ulvac, Inc., Chigasaki-shi Kanagawa 253-8543 (JP)
(72) Inventor: FUJII, Yoshinori, Susono-shi Shizuoka 410-1231 (JP); MOCHIZUKI, Nobuaki, Susono-shi Shizuoka 410-1231 (JP)
(74) Representative: Schaumburg, Thoenes, Thurn, Landskron, Eckert
(86) International application number: PCT/JP2008/061823
(87) International publication number: WO 2009/005027

(56) References cited:
- JP-A- 06 224 281
- JP-A- 2000 003 951
- JP-A- 2000 012 655
- JP-A- 2000 260 846
- US-A1- 2002 006 323
- US-A1- 2004 113 444
- US-B2- 6 634 686

## Description

### Technical Field

The present invention relates to a substrate transfer robot. More particularly, the present invention relates to a substrate transfer robot to be arranged in a transfer chamber in a multi-chamber type vacuum processing apparatus.

### Background Art

A multi-chamber type vacuum processing apparatus provided with a plurality of substrate processing chambers, a transfer chamber arranged substantially at the center of the plurality of substrate processing chambers and a substrate transfer robot for transferring a substrate to one of the plurality of substrate processing chambers is known. The substrate transfer robot has an extendable/retractable (or telescopic) arm section, a substrate receiving section at the front end of the arm section to receive a substrate to be transferred and slip preventing (or anti-slip) members arranged at a plurality of positions on the top surface of the substrate receiving section (parts corresponding to peripheral sections of the substrate mounted on the substrate receiving section) and having top surfaces to be tightly adhered to the rear surface of the substrate. The slip preventing members are made of an elastic material such as fluorine-based rubber and have a disk-like profile (see Patent Document 1).

There is also known a transfer mechanism having two holder sections for holding objects to be processed such as substrates, wherein one of the holder sections is provided with a plurality of tapered receiving members made of an elastic material and having tapered receiving surfaces, each of which is to be held in contact with an edge section of an object to be processed to support the object, and the other holder section is provided with a plurality of flat receiving members made of an elastic material and having flat receiving surfaces, each of which is to be held in contact with the rear surface of an object to be processed to support the object (see Patent Document 2).
Patent Document 1: JP-A-2006-261377
Patent Document 2: JP-A-2002-026108

Substrate transfer robots according to the preamble of claim 1 are disclosed in US 6 634 686 B2, US 2002/006323 A1, JP 2000 003951 A and US 2004/113444 A1.

JP 06 224281 discloses a wafer transfer jig having a plurality of slip preventing members arranged to support a peripheral portion of a wafer.

### Disclosure of the Invention

### Problem to Be Solved by the Invention

In a vacuum processing apparatus as described in Patent Document 1 or 2, a substrate is heated as it is processed in one of the processing chambers and starts to thermally contract on the corresponding substrate receiving section of the substrate transfer robot when it is transferred from the processing chamber to some other processing chamber by the substrate transfer robot. Then, there can arise instances where the tight adhesion between the rear surface of the substrate and the top surface of the substrate slip preventing member is no longer maintained because the thermally contracting force of the substrate is large relative to the static frictional force produced between the substrate slip preventing member and the substrate, and the radial distortion of the substrate on the substrate slip preventing member is small and insufficient, and/or because the substrate is warped at high temperature to reduce the effective contact area between the rear surface and the substrate slip preventing member. Then, the net result will be that the substrate drops down from the substrate slip preventing member or from the substrate receiving section of the substrate transfer robot while the substrate is being transferred by the substrate transfer robot.

When, on the other hand, the contact area between the substrate, or the object to be processed, and the top surface of the slip preventing member or the flat receiving member is large, the substrate, or the object to be processed, and the elastic material of the slip preventing member or the flat receiving member firmly adhere to each other (chemical bonding) so that the substrate, or the object to be processed, has to be peeled off at the firmly adhering part thereof at the time of delivery. Then, the substrate, or the object to be processed, can be displaced from the right position.

In view of the above-identified problems of the conventional art, it is therefore an object of the present invention to provide a substrate transfer robot that can reliably prevent the substrate being transferred from firmly adhering, being displaced and/or falling down and also a vacuum processing apparatus provided with such a substrate transfer robot.

### Means for Solving the Problem

In a first aspect of the present invention, the above object is achieved by providing a substrate transfer robot according to claim 1. In the latter arrangement, the protruding section arranged on the base wall may be cylindrical or show a T-shaped or semi-spherical longitudinal cross section.

### Advantages of the Invention

Thus, in the present invention, there is provided a substrate transfer robot including a substrate receiving section for receiving a substrate, a plurality of substrate slip preventing members arranged on the top surface of the substrate receiving section at intervals and made of an elastic material and an extendable/retractable arm section having the substrate receiving section arranged at the front end thereof, and each of the substrate slip preventing members is provided on the top end surface thereof with a protruding section. Therefore, if the substrate expands or contracts while it is being transferred, the expansion or contraction, whichever appropriate, is absorbed by the sufficient distortion of the substrate slip preventing members that arises in radial directions of the substrate so that the firm adhesion between the rear surface of the substrate and the top surfaces of the substrate slip preventing members is satisfactorily maintained. Additionally, if the substrate is warped, the contact area of the substrate fluctuates only to a small extent so that it can be reliably transferred.

Then, as a result, it is possible to reliably prevent instances where the substrate drops down from the substrate slip preventing members or from the substrate receiving section of the substrate transfer robot while the substrate is being transferred by the substrate transfer robot from taking place.

When the substrate slip preventing members of a substrate transfer robot are made of perfluoroelastomer, they are highly thermally resistant so that the distortion of the protruding section of each of the substrate slip preventing members can be satisfactorily maintained even if thermal contraction arises to a large extent while a very hot (300°C) substrate is being transferred. Thus, a substrate transfer robot according to the present invention can reliably and stably transfer a hot substrate.

When the surface coarseness of the top surface of the protruding section of each of the substrate slip preventing members is made Ra 1 µm or less, the static frictional force can be maintained to an appropriate level that is sufficient for transferring a very hot (300°C) substrate. The surface coarseness can be reduced by friction. However, the static frictional force can be maintained to an appropriate level for a long period of time by making the Ra low from the beginning.

A substrate transfer robot can become slack by fatigue in the direction in which it is extended and contracted. Therefore, if the protruding sections of the substrate slip preventing members have an excessively large height, some of the substrate slip preventing members can firstly touch the corresponding substrates at their protruding sections when the substrate transfer robot receives the substrate. Then, the protruding sections are subjected to an excessive load due to the weight of the substrate and can become bent to give rise to displacement of the substrate receiving position of the substrate transfer robot. However, when the height of the protruding sections of the substrate slip preventing members is determined according to the extent of distortion relative to a given transversal shear stress, it is possible to prevent a problem that such positional displacement persistently continues after the substrate is brought in some other processing chamber from taking place.

When the substrate slip preventing members are cylindrically formed and the substrate receiving section is provided with a plurality of through holes for removably receiving the cylindrical substrate slip preventing members in a substrate transfer robot according to the present invention, any of the substrate slip preventing members can be replaced with ease in a servicing operation (where one or more than one of the substrate slip preventing members are worn at the protruding sections thereof and hence need to be replaced).

When each of the slip preventing members is provided at the bottom end surface thereof with an auxiliary protruding section in a substrate transfer robot according to the present invention, the substrate slip preventing member or each of the substrate slip preventing members that needs to be serviced can be turned upside down and mounted in position once again in a servicing operation (where one or more than one of the substrate slip preventing members are worn at the protruding sections thereof and hence need to be replaced) so as to make it operate properly as substrate slip preventing member once again and prolong its service life.

When each of the substrate slip preventing members is provided at the top end surface thereof with a plurality of protruding sections arranged circumferentially at intervals in a substrate transfer robot according to the present invention, the distortion of the substrate that arises due to temperature and/or weight can be distributed and the influence of the firm adhesion between the substrate and the protruding section (chemical binding) can be reduced.

When each of the substrate slip preventing members is provided with a base wall for arranging a protruding section thereon and the base wall is formed in the internal space of the cylindrical substrate slip preventing member in a substrate transfer robot according to the present invention, its substrate supporting characteristics can be satisfactorily guaranteed, taking the influence of thermal expansion and other factors into consideration, within a tolerance of a bus line for transferring substrates.

Thus, it is possible to reliably prevent instances where the substrate drops down from the substrate slip preventing member or from the substrate receiving section of the substrate transfer robot while the substrate is being transferred by the substrate transfer robot from taking place. Thus, it is possible to provide a vacuum processing apparatus provided with a stable transfer system.

### Brief Description of the Drawings

FIG. 1 is a schematic illustration of a principal part of a substrate transfer robot according to the present invention.
FIG. 2 is an enlarged schematic illustration of a substrate receiving section of the substrate transfer robot of FIG. 1.
FIG. 3 is a schematic illustration of a vacuum processing apparatus where the substrate transfer robot as shown in FIG. 1 is incorporated.
FIG. 4 is a schematic cross-sectional view of a substrate slip preventing member that can be used for a substrate transfer robot according to the present invention taken along a center line thereof.
FIG. 5 is a schematic top view of the substrate slip preventing member of FIG. 4.
FIG. 6 is an enlarged schematic lateral view of a protruding section of the substrate slip preventing member of FIG. 4.
FIG. 7 is an enlarged schematic illustration of a substrate slip preventing member that can be used for a substrate transfer robot according to the present invention.
FIG. 8 is a schematic cross-sectional view of the substrate slip preventing member of FIG. 7 taken along a center line thereof.
FIG. 9 is a schematic top view of the substrate slip preventing member of FIG. 7.
FIG. 10 is an enlarged schematic cross-sectional view of a principal part of the substrate slip preventing member of FIG. 8.
FIG. 11 is a schematic cross-sectional view of a substrate slip preventing member that can be used for a substrate transfer robot according to the present invention taken along a center line thereof.
FIG. 12 is a schematic cross-sectional view of a substrate slip preventing member that can be used for a substrate transfer robot according to the present invention taken along a center line thereof.
FIG. 13 is a schematic cross-sectional view of a substrate slip preventing member that can be used for a substrate transfer robot according to the present invention taken along a center line thereof.
FIG. 14 is a schematic cross-sectional view of a substrate slip preventing member that can be used for a substrate transfer robot according to the present invention taken along a center line thereof.
FIG. 15 is a schematic cross-sectional view of a substrate slip preventing member that can be used for a substrate transfer robot according to the present invention taken along a center line thereof.
FIG. 16 is a schematic cross-sectional view of a substrate slip preventing member that can be used for a substrate transfer robot according to the present invention taken along a center line thereof.

### Best Mode for Carrying Out the Invention

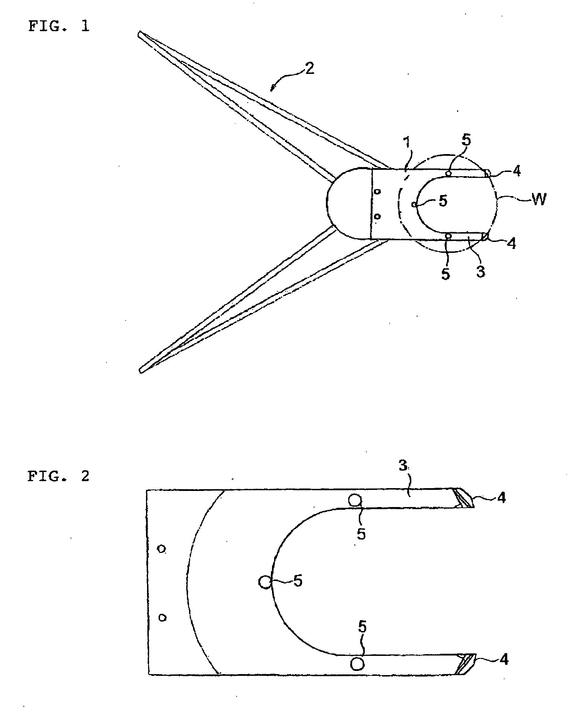

FIGS. 1 and 2 schematically illustrate a substrate transfer robot according to the present invention. In FIGS. 1 and 2, 1 denotes a substrate receiving section for receiving a substrate W, which substrate receiving section 1 is fitted to an arm section 2 that is made to be vertically movable and extendable/retractable by means of a multi-joint mechanism. The arm section 2 is connected to a drive mechanism (not shown) for driving the arm section 2 to move up and down and also for extending/retracting the arm section 2.

As shown in FIG. 2, the substrate receiving section 1 has substrate supporting surfaces 3 and stopper members 4 are formed at the front ends of the substrate supporting surfaces 3 to show a fork-like profile in order to receive a substrate W. A total of three substrate slip preventing members 5 that are made of an elastic material are arranged at intervals on the substrate supporting surface 3.

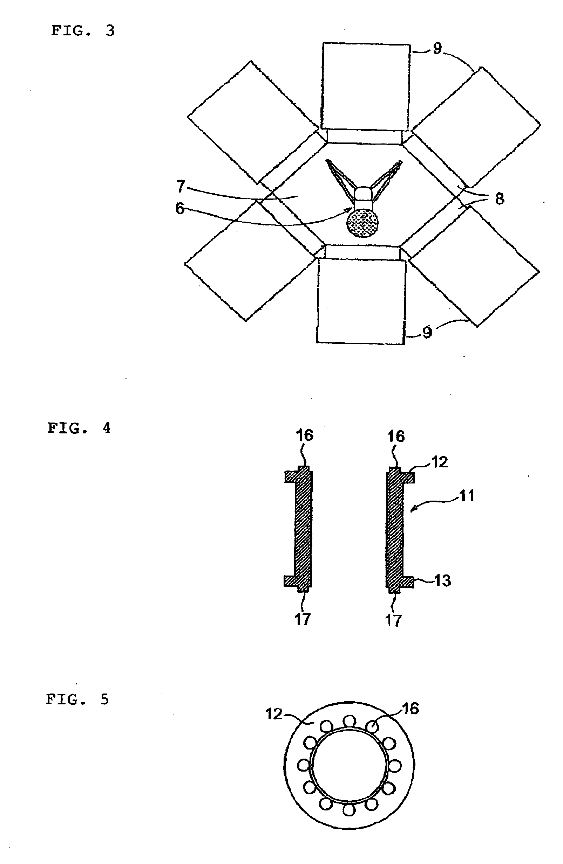

FIG. 3 schematically illustrates a multi-chamber type vacuum processing apparatus having a substrate transfer robot as shown in FIG. 1. In the illustrated instance, the substrate transfer robot 6 is arranged in a heptagonal substrate transfer chamber 7, which heptagonal substrate transfer chamber 7 is surrounded by four substrate processing chambers 9 and four substrate reception/delivery chambers 10 by way of respective gate valves 8.

FIGS. 4 through 6 schematically illustrate a substrate slip preventing member that can be used for a substrate transfer robot according to the present invention. The illustrated substrate slip preventing member 11 has a hollow cylindrical profile with an outer diameter of 3.5 mm, an inner diameter of 2 mm and a height of 2.4 mm. It is made of a highly heat-resistant material such as perfluoroelastomer, which may typically be Kalrez 7075 (trade name), or fluorine-based rubber. The cylindrical substrate slip preventing member 11 is provided at the top end and at the bottom end thereof respectively with an upper outer flange 12 and a lower outer flange 13 each having a thickness of 0.3 mm, which define the top end surface 14 and the bottom end surface 15 of the substrate slip preventing member 11. The distance between the upper outer flange 12 and the lower outer flange 13 is 1.8 mm.

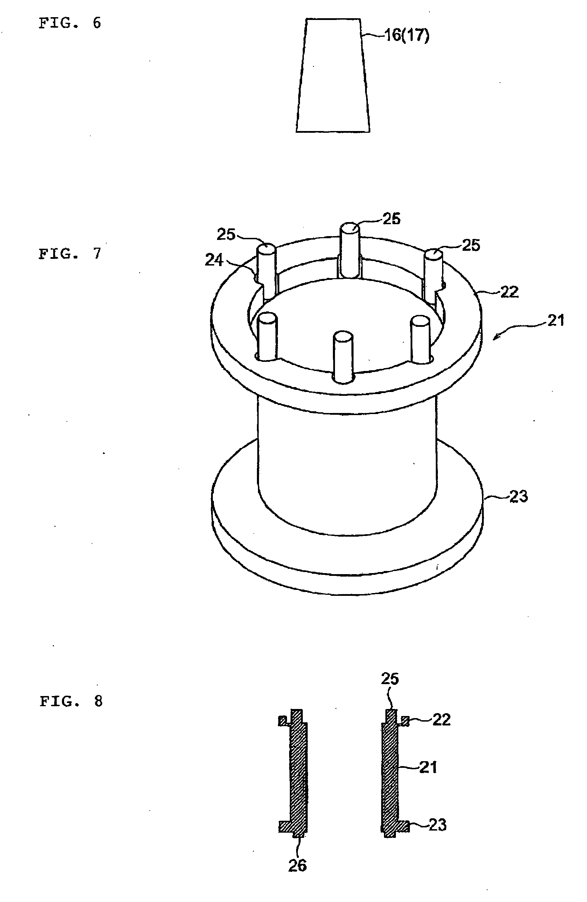

As shown in FIG. 5, the top end surface 14 and the bottom end surface 15 of the cylindrical substrate slip preventing member 11 are respectively provided with twelve protruding sections 16 and twelve protruding sections 17 that are integral with the top end surface 14 and the bottom end surface 15 and arranged at regular intervals. As shown in FIG. 6, each of the protruding sections 16, 17 shows a frusto-conical profile with a top diameter of 0.2 mm, a bottom diameter of 0.25 mm and a height of 0.4 mm. Note, however, that these dimensions are not critical and the protruding sections are designed to alleviate the shear stress that is produced by the thermal expansion of the substrate being transferred. In other words, the protruding sections may be made to show some other appropriate profile depending on the temperature difference that may arise, the diameter of the substrate being transferred, the locations of arrangement of the cylindrical substrate slip preventing members 11 and the adsorption area so long as they can alleviate the stress. Differently stated, while the protruding sections are temporarily made to adhere to the substrate W to be transferred chemically or physically, they may become no longer adsorbed to the substrate W when the adsorption surfaces are subjected to shear stress. In view of this problem, according to the present invention, the protruding sections are so designed as to be distorted when they are subjected to shear stress due to thermal expansion or thermal contraction on the part of the substrate W in order to reduce the shear stress applied to the adsorption surfaces and maintain the adsorption.

The cylindrical substrate slip preventing members 11 that are formed in the above-described manner are put into the respective fitting holes arranged on the substrate supporting surfaces 3a, 3b of the substrate receiving section as shown in FIG. 2 and the upper outer flange 12 and the lower outer flange 13 of each of the substrate slip preventing members 11 are made to tightly engage with the inner peripheral edge of the corresponding fitting hole.

In the illustrated example, each of the cylindrical substrate slip preventing members 11 is provided on the top end surface 14 and the bottom end surface 15 thereof respectively with protruding sections 16 and protruding sections 17 to show a vertically symmetrical profile and hence the cylindrical substrate slip preventing members 11 can be used to serve for twice when they are turned upside down. However, each of the cylindrical substrate slip preventing members 11 may be provided only on the top end surface 14 thereof with protruding sections 16.

FIGS. 7 through 10 schematically illustrate a substrate slip preventing member that can be used for a substrate transfer robot according to the present invention. In the illustrated instance, a substrate slip preventing member 21 is made to show a hollow cylindrical profile with an outer diameter of 3.5 mm, an inner diameter of 2 mm and a height of 2.4 mm. It is made of a highly heat-resistant material such as perfluoroelastomer, which may typically be Kalrez 7075 (trade name), or fluorine-based rubber, like in FIG. 4. The cylindrical substrate slip preventing member 21 is provided at the top end and at the bottom end thereof respectively with an upper outer flange 22 and a lower outer flange 23, which flanges 22, 23 have a thickness of 0.3 mm.

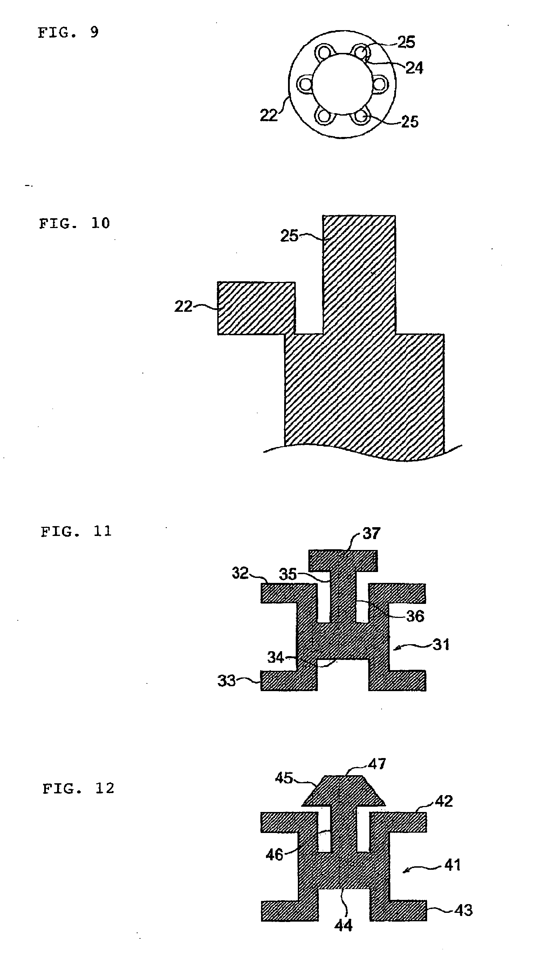

The upper outer flange 22 arranged at the top end of the cylindrical substrate slip preventing member 21 is provided with six 0.3 mm-deep recesses 24 formed along the inner periphery of the cylindrical substrate slip preventing member 21 as shown in FIGS. 7 and 9. Each of the recesses 24 is axially upwardly and radially inwardly open. The bottom of each of the recesses 24 defines the top end surface on which a cylindrical protruding section 25 is integrally formed. The peripheral surface of each of the cylindrical protruding sections 25 is separated from the lateral wall of the corresponding recess 24 by a gap. In the illustrated instance, the cylindrical protruding sections 25 have a diameter of 0.3 mm and a height of 0.6 mm. In this instance again, these dimensions are not critical and the protruding sections may be made to have different dimensions depending on the temperature difference that may arise, the diameter of the substrate being transferred, the locations of arrangement of the cylindrical substrate slip preventing members 21 and the adsorption area so long as they can alleviate the stress.

Similarly, the lower outer flange 23 arranged at the bottom end of the cylindrical substrate slip preventing member 21 is provided with six 0.3 mm-deep recesses (not shown) formed along the inner periphery of the cylindrical substrate slip preventing member 21 so as to be axially downwardly and radially inwardly open. A cylindrical protruding section 26 is integrally formed on the bottom of each of the recesses. In the illustrated instance, the cylindrical protruding sections 26 have a diameter of 0.3 mm and a height of 0.6 mm.

The apparent height of the cylindrical protruding sections 25 can be reduced as they are formed on the bottom surfaces of the respective recesses 24, which is advantageous for constructing a substrate transfer robot. Differently stated, the pickup height of an ordinary robot is not allowed to be sufficiently large and subjected to a severe limit. More specifically, the protruding sections are allowed to have a height of only about 0.3 mm. Under these circumstances, it is highly advantageous when the cylindrical protruding sections 25 can have a height that is sufficient for making them flexible.

FIG. 11 schematically illustrates still a substrate slip preventing member that can be used for a substrate transfer robot according to the present invention. In the illustrated instance, a substrate slip preventing member 31 shows a cylindrical profile and is made of a highly heat-resistant material such as perfluoroelastomer, which may typically be Kalrez 7075 (trade name), or fluorine-based rubber. The cylindrical substrate slip preventing member 31 is provided at the top end and also at the bottom end thereof respectively with an upper outer flange 32 and a lower outer flange 33.

A base wall 34 is formed in the inside of the cylindrical substrate slip preventing member 31 and a single protruding section 35 showing a T-shaped longitudinal cross section is formed on the top surface of the base wall 34. The protruding section 35 includes a cylindrical pillar section 36 and a circular head section 37. The contact area between the circular head section 37 and a substrate is determined by the diameter of the circular head section 37, and the length and the diameter of the cylindrical pillar section 36 are so selected that the shear stress applied to the circular head section 37 due to thermal expansion or thermal contraction of the substrate W supported on the cylindrical substrate slip preventing member 31 is reduced to maintain the adsorption of the substrate.

FIG. 12 schematically illustrates still a substrate slip preventing member that can be used for a substrate transfer robot according to the present invention. In the illustrated instance, a substrate slip preventing member 41 shows a cylindrical profile and is made of a highly heat-resistant material such as perfluoroelastomer, which may typically be Kalrez 7075 (trade name), or fluorine-based rubber, like in FIG. 11. The cylindrical substrate slip preventing member 41 is provided at the top end and at the bottom end thereof respectively with an upper outer flange 42 and a lower outer flange 43.

A base wall 44 is formed in the inside of the cylindrical substrate slip preventing member 41 and a single protruding section 45 showing a mushroom-shaped cross section is formed on the top surface of the base wall 44. The protruding section 45 includes a cylindrical pillar section 36 and an umbrella-shaped head section 47. The contact area between the umbrella-shaped head section 47 and a substrate is determined by the diameter of top surface of the umbrella-shaped head section 47 and the length and the diameter of the cylindrical pillar section 36 are so selected that the shear stress applied to the umbrella-shaped head section 47 due to thermal expansion or thermal contraction of the substrate W supported on the cylindrical substrate slip preventing member 41 is reduced to maintain the adsorption of the substrate.

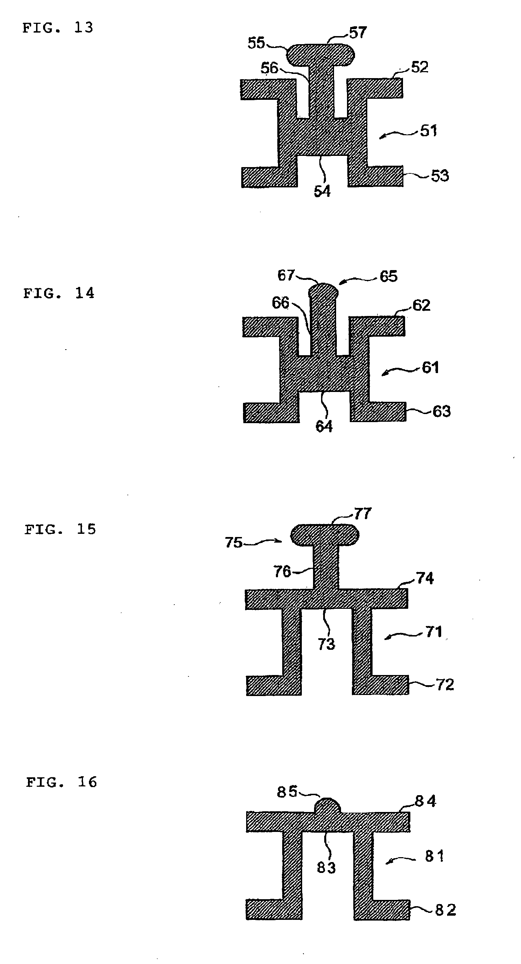

FIG. 13 schematically illustrates still a substrate slip preventing member that can be used for a substrate transfer robot according to the present invention. The illustrated instance is substantially the same as the instance of FIG. 11. More specifically, the substrate slip preventing member 51 shows a cylindrical profile and is made of a highly heat-resistant material such as perfluoroelastomer, which may typically be Kalrez 7075 (trade name), or fluorine-based rubber. The cylindrical substrate slip preventing member 51 is provided at the top end and also at the bottom end thereof respectively with an upper outer flange 52 and a lower outer flange 53.

A base wall 54 is formed in the inside of the cylindrical substrate slip preventing member 51 and a single protruding section 55 showing a T-shaped longitudinal cross section is formed on the top surface of the base wall 54. The protruding section 55 includes a cylindrical pillar section 56 and a disk-shaped head section 57, of which the disk-shaped head section 57 is beveled (or rounded) along the peripheral edges thereof. The contact area between the disk-shaped head section 57 and a substrate is determined by the diameter of the disk-shaped head section 57, excluding the beveled (or rounded) edges, and the length and the diameter of the cylindrical pillar section 56 are so selected that the shear stress applied to the disk-shaped head section 57 due to thermal expansion or thermal contraction of the substrate W supported on the cylindrical substrate slip preventing member 51 is reduced to maintain the adsorption of the substrate.

FIG. 14 schematically illustrates still a substrate slip preventing member that can be used for a substrate transfer robot according to the present invention. In the illustrated instance again, a substrate slip preventing member 61 shows a cylindrical profile and is made of a highly heat-resistant material such as perfluoroelastomer, which may typically be Kalrez 7075 (trade name), or fluorine-based rubber. The cylindrical substrate slip preventing member 61 is provided at the top end and also at the bottom end thereof respectively with an upper outer flange 62 and a lower outer flange 63.

A base wall 64 is formed in the inside of the cylindrical substrate slip preventing member 61 and a single substantially cylindrical protruding section 65 is formed on the top surface of the base wall 64. The protruding section 65 includes a cylindrical pillar section 66 and a semi-spherical head section 67 having a diameter slightly greater than the cylindrical pillar section 66. The length and the diameter of the cylindrical pillar section 66 are so selected that the shear stress applied to the semi-spherical head section 67 due to thermal expansion or thermal contraction of the substrate W supported on the cylindrical substrate slip preventing member 61 is reduced to maintain the adsorption of the substrate.

FIG. 15 is a schematic illustration of a substrate slip preventing member according to the present invention that is obtained by modifying the example of FIG. 13. The illustrated substrate slip preventing member 71 shows a cylindrical profile and is made of a highly heat-resistant material such as perfluoroelastomer, which may typically be Kalrez 7075 (trade name), or fluorine-based rubber. The cylindrical substrate slip preventing member 71 is provided at the bottom end with a lower outer flange 72.

The cylindrical substrate slip preventing member 71 is provided at the top end thereof with a base wall 73 and the outer end of the base wall 73 defines an upper outer flange 74 that is arranged vis-à-vis the lower outer flange 72 at the bottom end. A single protruding section 75 showing a T-shaped longitudinal cross section is formed at the center of the top surface of the base wall 73. The protruding section 75 includes a cylindrical pillar section 76 and a disk-shaped head section 77, of which the disk-shaped head section 77 is beveled (or rounded) along the peripheral edges thereof. The contact area between the disk-shaped head section 77 and a substrate is determined by the diameter of the head section 77, excluding the beveled (or rounded) edges, and the length and the diameter of the cylindrical pillar section 76 are so selected that the shear stress applied to the disk-shaped head section 77 due to thermal expansion or thermal contraction of the substrate W supported on the cylindrical substrate slip preventing member 71 is reduced to maintain the adsorption of the substrate.

FIG. 16 is a schematic illustration of a substrate slip preventing member according to the present invention that is obtained by modifying the example of FIG. 15. The illustrated substrate slip preventing member 81 shows a cylindrical profile and is made of a highly heat-resistant material such as perfluoroelastomer, which may typically be Kalrez 7075 (trade name), or fluorine-based rubber. The cylindrical substrate slip preventing member 81 is provided at the bottom end thereof with a lower outer flange 82.

The cylindrical substrate slip preventing member 81 is provided at the top end thereof with a base wall 83 and the outer end of the base wall 83 defines an upper outer flange 84 that is arranged vis-à-vis the lower outer flange 82 at the bottom end. A single protruding section 85 showing a semi-spherical longitudinal cross section is formed at the center of the top surface of the base wall 83. This arrangement can minimize the influence of the warp, if any, of the substrate and relatively reduce the influence of the thermal contraction of the substrate.

The upper limit of the height of the protruding section of the substrate slip preventing member is determined within a tolerance of a bus line for transferring substrates. On the other hand, the lower limit is defined in such a way that the substrate slip preventing member does not contact any other components if the substrate is warped.

Furthermore, in the substrate slip preventing member, the lower limit of the diameter of the protruding section should be determined according to the strength of the protruding section and the upper limit of the diameter of the protruding section should be determined according to the height and the diameter thereof and the required extent of distortion (the transversal flexibility). As for the lower limit, the protruding section can yield to the adsorptive force at the contacting part of the protruding section and become torn away if the diameter of the protruding section is too small relative to the contact area. Thus, the upper limit should be determined according to the material of the protruding section. As for the upper limit, the profile of the protruding section needs to follow the thermal expansion of the substrate and hence the upper limit should be so defined that the protruding section does not move away from the adsorption surface if it is forced to move by thermal expansion. The protruding section may have a considerably large diameter if it is made of gel-like soft rubber. Then, the effective contact area is large so that the area of the contacting part of the protruding section needs to be reduced.

When the protruding section of the substrate slip preventing member is too weak, it can be distorted to constantly give rise to a displacement of the substrate in a certain direction in the operation of delivering it from the lift pin to the pickup. Thus, the mechanical strength of the protruding section needs to be so determined that the protruding section maintains a level of strength that prevents it from being distorted if it is subjected to a load that is equal to a half of the weight of a substrate at a single point thereof. Additionally, the pickup of a robot is turned slack by fatigue in the direction in which it is extended and contracted to make the extent of parallelism between the lift pin and the pickup variable. If the robot receives a substrate from a lifter by means of the pickup under such a condition, the substrate rides on the substrate slip preventing member not at three points simultaneously but only at a point to begin with. Then, if the protruding section of the substrate slip preventing member can no longer support the substrate and becomes distorted, the substrate will be displaced from the right position. Therefore, the protruding section needs to be provided with a sufficient degree of mechanical strength and the pickup and the lifter need to be rigorously held in parallel with each other under a condition where the arm of the robot is extended in order to avoid such a situation.

The cylindrical substrate slip preventing members are brought into engagement with the respective fitting holes arranged on the substrate supporting surfaces of the substrate receiving section and hence the cylindrical substrate slip preventing members can be made hollow so as to be driven into the respective fitting holes by force. However, the cylindrical substrate slip preventing members may not necessarily be made hollow but have some other structure when they are brought into respective positions by screwing, press fitting or bonding.

### Explanation of Reference Symbols

- 1:: substrate receiving section
- 2:: arm section
- 3:: substrate supporting surface
- 4:: stopper member
- 5:: substrate slip preventing member
- 6:: substrate transfer robot
- 7:: substrate transfer chamber
- 8:: gate valve
- 9:: substrate processing chamber
- 10:: substrate reception/delivery chamber
- 11:: cylindrical substrate slip preventing member
- 12:: upper outer flange
- 13:: lower outer flange
- 14:: top end surface
- 15:: bottom end surface
- 16, 17:: protruding section
- 21:: cylindrical substrate slip preventing member
- 22:: upper outer flange
- 23:: lower outer flange
- 24:: recess
- 25:: cylindrical protruding section
- 26:: cylindrical protruding section
- 31:: cylindrical substrate slip preventing member
- 32:: upper outer flange
- 33:: lower outer flange
- 34:: base wall
- 35:: protruding section
- 36:: cylindrical pillar section
- 37:: head section
- 41:: cylindrical substrate slip preventing member
- 42:: upper outer flange
- 43:: lower outer flange
- 44:: base wall
- 45:: protruding section
- 46:: cylindrical pillar section
- 47:: umbrella-shaped head section
- 51:: cylindrical substrate slip preventing member
- 52:: upper outer flange
- 53:: lower outer flange
- 54:: base wall
- 55:: protruding section
- 56:: cylindrical pillar section
- 57:: disk-shaped head section
- 61:: cylindrical substrate slip preventing member
- 62:: upper outer flange
- 63:: lower outer flange
- 64:: base wall
- 65:: protruding section
- 66:: cylindrical pillar section
- 67:: semi-spherical head section
- 71:: cylindrical substrate slip preventing member
- 72:: lower outer flange
- 73:: base wall
- 74:: upper outer flange
- 75:: protruding section
- 76:: cylindrical pillar section
- 77:: disk-shaped head section
- 81:: cylindrical substrate slip preventing member
- 82:: lower outer flange
- 83:: base wall
- 84:: upper outer flange
- 85:: protruding section

## Claims

1. A substrate transfer robot (6) comprising:
a substrate receiving section (1) for receiving a substrate (W);
a plurality of substrate slip preventing members (31, 41, 51, 61, 71, 81) arranged on the top surface of the substrate receiving section (1) at intervals and made of an elastic material; and
an extendable/retractable arm sections (2) having the substrate receiving section (1) arranged at the front end thereof, wherein
each of the substrate slip preventing members (31, 41, 51, 61, 71, 81) is provided at the top end surface thereof with a protruding section (35, 45, 55, 65, 75, 85) for contacting a rear surface of the substrate (W);
wherein the substrate slip preventing members (5, 11, 21, 31, 41, 51, 61, 71, 81) are cylindrical and the substrate receiving section (1) is provided with a plurality of through holes for removably receiving the cylindrical substrate slip preventing members (5, 11, 21, 31, 41, 51, 61, 71, 81),
**characterized in that** each of the cylindrical substrate slip preventing members (31, 41, 51, 61, 71, 81) is provided with a base wall (34, 44, 54, 64, 73, 83) for arranging the protruding section (35, 45, 55, 65, 75, 85) thereon, and the base wall (34, 44, 54, 64, 73, 83) is formed on the top end surface or in the internal space of the cylindrical substrate slip preventing members (31, 41, 51, 61, 71, 81).

2. The substrate transfer robot (6) according to claim 1, **characterized in that** the protruding section (35, 45, 55, 65, 75, 85) arranged on the base wall (34, 44, 54, 64, 73, 83) has a cylindrical profile or a T-shaped longitudinal cross section.

## Patentansprüche

1. Substratübertragungsroboter (6) mit:
einem Substrataufnahmeabschnitt (1) zum Aufnehmen eines Substrats (W);
einer Vielzahl von Elementen (31, 41, 51, 61, 71, 81) zur Vermeidung des Verrutschens des Substrats, die auf der oberen Fläche des Substrataufnahmeabschnitts (1) in Abständen angeordnet sind und aus einem elastischen Material bestehen; und
einem ausziehbaren/einziehbaren Armabschnitt (2), wobei der Substrataufnahmeabschnitt (1) an dessen vorderem Ende angeordnet ist, wobei
jedes der Elemente (31, 41, 51, 61, 71, 81) zur Vermeidung des Verrutschens des Substrats an seiner oberen Endfläche mit einem vorstehenden Abschnitt (35, 45, 55, 65, 75, 85) zum Kontaktieren einer Rückfläche des Substrats (W) ausgestattet ist;
wobei die Elemente (5, 11, 21, 31, 41, 51, 61, 71, 81) zur Vermeidung des Verrutschens des Substrats zylindrisch sind und der Substrataufnahmeabschnitt (1) mit einer Vielzahl von Durchgangslöchern zum lösbaren Aufnehmen der zylindrischen Elemente (5, 11, 21, 31, 41, 51, 61, 71, 81) zur Vermeidung des Verrutschens des Substrats ausgestattet ist,
**dadurch gekennzeichnet, dass** jedes der zylindrischen Elemente (31, 41, 51, 61, 71, 81) zur Vermeidung des Verrutschens des Substrats mit einer Grundwand (34, 44, 54, 64, 73, 83) zum Anordnen des vorstehenden Abschnitts (35, 45, 55, 65, 75, 85) darauf ausgestattet ist, und die Grundwand (34, 44, 54, 64, 73, 83) auf der oberen Endfläche oder in dem Innenraum der zylindrischen Elemente (31, 41, 51, 61, 71, 81) zur Vermeidung des Verrutschens des Substrats gebildet ist.

2. Substratübertragungsroboter (6) nach Anspruch 1, **dadurch gekennzeichnet, dass** der auf der Grundwand (34, 44, 54, 64, 73, 83) angeordnete vorstehende Abschnitt (35, 45, 55, 65, 75, 85) ein zylindrisches Profil oder einen T-förmigen Längsschnitt hat.

## Revendications

1. Robot de transfert de substrat (6) comprenant :
- une section de réception du substrat (1) destinée à recevoir un substrat (W) ;
- une pluralité d'éléments préventifs de glissement du substrat (31, 41, 51, 61, 71, 81) agencés sur la surface supérieure de la section de réception du substrat (1) à des intervalles et constitués de matière élastique ; et
- une section de bras extensible/rétractable (2) ayant la section de réception du substrat (1) agencée sur son extrémité avant, dans laquelle :
chacun des éléments préventifs de glissement du substrat (31, 41, 51, 61, 71, 81) est muni, à sa surface d'extrémité supérieure, d'une section faisant saillie (35, 45, 55, 65, 75, 85) destinée à entrer en contact avec une surface arrière du substrat (W) ;
dans lequel les éléments préventifs de glissement du substrat (5, 11, 21, 31, 41, 51, 61, 71, 81) sont cylindriques et la section de réception du substrat (1) est munie d'une pluralité de trous traversants afin de recevoir, de manière amovible, les éléments cylindriques préventifs de glissement du substrat (5, 11, 21, 31, 41, 51, 61, 71, 81),
**caractérisé en ce que** chacun des éléments cylindriques préventifs de glissement du substrat (31, 41, 51, 61, 71, 81) est muni d'une paroi de base (34, 44, 54, 64, 73, 83) afin d'agencer la section faisant saillie (35, 45, 55, 65, 75, 85) sur celle-ci, et la paroi de base (34, 44, 54, 64, 73, 83) est formée sur la surface d'extrémité supérieure ou dans l'espace interne des éléments cylindriques préventifs de glissement du substrat (31, 41, 51, 61, 71, 81).

2. Robot de transfert de substrat (6) selon la revendication 1, **caractérisé en ce que** la section faisant saillie (35, 45, 55, 65, 75, 85) agencée sur la paroi de base (34, 44, 54, 64, 73, 83) présente un profil cylindrique ou une section longitudinale en forme de T.
